# EUROPÄISCHE PATENTSCHRIFT

(11) **EP 0 967 616 B1**
(45) Veröffentlichungstag und Bekanntmachung des Hinweises auf die Patenterteilung: **30.08.2006**
(21) Anmeldenummer: 99111226.9
(22) Anmeldetag: 09.06.1999
(51) Int. Cl.: G11C 7/00

(54) **Integrierter Speicher**
Integrated memory
Mémoire intégrée

(30) Priorität: 26.06.1998 DE 19828657
(43) Veröffentlichungstag der Anmeldung: 29.12.1999
(73) Patentinhaber: Infineon Technologies AG, 81669 München (DE)
(72) Erfinder: Schöniger, Sabine, 81737 München (DE); Dietrich, Stefan, Dr., 82299 Türkenfeld (DE); Schrögmeier, Peter, 81547 München (DE); Marx, Thilo, 80997 München (DE); Hein, Thomas, 81667 München (DE)
(74) Vertreter: Epping - Hermann - Fischer

(56) Entgegenhaltungen:
- EP-A- 0 591 850
- US-A- 5 015 891
- US-A- 5 160 861
- US-A- 5 283 760
- US-A- 5 710 737

## Beschreibung

Die Erfindung betrifft einen integrierten Speicher mit einem Datenleitungspaar, das über wenigstens einen Differenzverstärker mit einem Bitleitungspaar verbunden ist, wobei Daten in Form von Differenzsignalen vom Datenleitungspaar über den Differenzverstärker zum Bitleitungspaar und von dort in daran angeschlossene Speicherzellen übetragen werden.

Ein derartiger Speicher in Form eines DRAMs ist in Betty Prince: "Semiconductor Memories - a handbook of Design, Manufacture and Application", 2. Auflage, John Wiley and Sons, West Sussex, 1996, auf Seite 258, Abbildung 6.26a dargestellt. Beim Differenzverstärker handelt es sich um einen Schreib/Leseverstärker, das heißt Daten sind zwischen dem Datenleitungspaar und dem Bitleitungspaar in beide Richtungen übertragbar. Im folgenden soll nur ein Schreibvorgang des DRAMs betrachtet werden. Soll eine logische "1" in eine der Speicherzellen eingeschrieben werden, wird eine Leitung des Datenleitungspaares auf ein hohes Potential gebracht und die andere Leitung auf ein niedriges. Soll eine logische "0" geschrieben werden, sind demgegenüber die Potentiale auf den beiden Leitungen vertauscht.

Es ist üblich, daß beide Leitungen des Datenleitungspaares bei einem Lesevorgang vor dem Auslesen einer Speicherzelle auf das gleiche Potential vorgeladen werden (sogenanntes Precharging). Beispielsweise können hierzu beide Leitungen des Datenleitungspaares auf ein hohes Potential gebracht werden. Beim anschließenden Auslesen einer Speicherzelle beeinflußt dessen Inhalt über die Bitleitungen und den Schreib/Leseverstärker das vorgeladene Potential auf dem Datenleitungspaar.

In US 5,283,760 A ist ein Datenübertragungs-Schaltkreis eines Halbleiterspeichers beschrieben, bei dem Datenleitungen eines Datenleitungspaars über jeweilige Eingangstransistoren mit jeweiligen Bitleitungen eines Bitleitungspaars verbunden sind. Die Eingangstransistoren werden durch Signale auf den Datenleitungen des Datenleitungspaars in einem bestimmten Betriebszustand ausgeschalten, um eine elektrische Verbindung zwischen den Bitleitungen und den Datenleitungen in diesem Betriebszustand zu verhindern.

In EP 0 591 850 A2 wird ein Halbleiterspeicher beschrieben, bei dem über einen Datenbus Lese- und Schreibdaten zwischen einem Speicherarray und einem Eingangspuffer bzw. einem Ausgangspuffer transferiert werden. Weiterhin werden über den Datenbus Informationen transferiert, die einen Lese- oder Schreibmodus anzeigen. Die Schreibdaten werden über den Datenbus als komplementäre Signale transferiert, die eine grö-ßere Amplitude aufweisen als die Lesedaten. Das Speicherarray erkennt die Schreibdatensignale anhand der entsprechenden Amplitude. Dazu weist das Speicherarray ein Schreib-Control-Gate auf, um die Amplitude des komplementären Signals auf dem Datenbus zu detektieren.

In US 5,710,737 A ist ein Halbleiterspeicher beschrieben, bei dem ein Eingabe-Ausgabe-Schaltkreis an eine Adress-Verscrambelungs-Einheit angeschlossen ist. Die Adress-Verscrambelungs-Einheit empfängt Eingabedaten und konvertiert diese Eingabedaten in Schreibdaten in Abhängigkeit eines Burn-In Modussignals. Dabei bestimmt ein Reihenadresssignal während des Burn-In Tests, ob die Eingabedaten als invertierte Schreibdaten bzw. als nicht invertierte Schreibdaten ausgegeben werden. Dies wird beispielsweise davon abhängig gemacht, ob eine Wortleitung einer geraden Nummer ausgewählt wurde, wobei in diesem Fall die Eingabedaten nicht invertiert werden.

Der Erfindung liegt die Aufgabe zugrunde, einen integrierten Speicher der eingangs genannten Art anzugeben, bei dem Funktionen über größere Entfernungen steuerbar sind, ohne daß hierfür spezielle Steuerleitungen benötigt werden.

Diese Aufgabe wird mit einem integrierten Speicher gemäß Anspruch 1 gelöst.

Der erfindungsgemäße integrierte Speicher weist eine Steuereinheit auf, die einerseits zum Einstellen von ersten Potentialzuständen auf dem Datenleitungspaar dient, die den Differenzsignalen von in die Speicherzelle einzuschreibenden Daten entsprechen und andererseits zum Einstellen wenigstens eines zweiten Potentialzustands auf dem Datenleitungspaar dient, der keinem in die Speicherzellen einzuschreibendem Datum entspricht. Weiterhin weist der Speicher eine Detektoreinheit mit zwei Eingängen auf, von denen jeder mit einer Leitung des Datenleitungspaares verbunden ist. Die Detektoreinheit leitet bei Auftreten des zweiten Potentialzustands des Datenleitungspaares die gewünschte Steuerfunktion ein.

Während es sich bei den ersten Potentialzuständen also um solche handelt, die auf dem Datenleitungspaar auftreten, sofern Daten, die diesen ersten Potentialzuständen entsprechen, in Form eines sich daraus ergebenden Differenzsignals auf dem Datenleitungspaar über den Differenzverstärker zu einer der Speicherzellen übertragen werden (zum Beispiel erste Leitung des Datenleitungspaares niedriges Potential, zweite Leitung hohes Potential beim Einschreiben einer logischen "0", hohes Potential auf der ersten Leitung und niedriges Potential auf der zweiten Leitung beim Einschreiben einer logischen "1"), tritt der zweite Potentialzustand normalerweise bei einem Schreibvorgang nicht auf. Ein Beispiel für den zweiten Potentialzustand ist das Vorliegen eines niedrigen Potentials auf beiden Leitungen des Datenleitungspaares. Die Detektoreinheit erkennt das Vorliegen dieses zweiten Potentialzustands und löst daraufhin die gewünschte Steuerfunktion aus.

Die Erfindung bietet den Vorteil, daß das für das Schreiben und Lesen ohnehin notwendige Datenleitungspaar zusätzlich zu seiner üblichen Funktion auch zur Übermittlung des zweiten Potentialzustands an die Detektoreinheit und damit zur Auslösung der Steuerfunktion dient. Daher muß zu diesem Zwecke keine zusätzliche Steuerleitung im integrierten Speicher vorgesehen werden, die insbesondere bei größeren zu überbrückenden Entfernungen einen erheblichen Platzaufwand erfordern würde. Bei der Erfindung überbrücken die Leitungen des Datenleitungspaares die gewünschte Distanz von der Steuereinheit zu der die Steuerfunktion einleitenden Detektoreinheit.

Beispielsweise deaktiviert die Detektoreinheit bei Auftreten des zweiten Potentialzustands auf dem Datenleitungspaar den Differenzverstärker. Ist der Differenzverstärker ein Schreib-/Leseverstärker, wird hierdurch verhindert, daß aus einer Speicherzelle auf die zugehörigen Bitleitungen ausgelesene Daten ungewollt über den Differenzverstärker auf die Datenleitungen gelangen. Dies ist insbesondere dann von Vorteil, wenn das Datenleitungspaar mit mehreren Differenzverstärkern verbunden ist, von denen jeder über je ein Bitleitungspaar mit entsprechenden Speicherzellen verbunden ist. Durch je eine Detektoreinheit pro Differenzverstärker lassen sich dann bei Vorliegen des zweiten Potentialzustands auf dem Datenleitungspaar alle Differenzverstärker gleichzeitig deaktivieren, so daß vermieden wird, daß gleichzeitig mehrere der Differenzverstärker ungewollt Daten auf das Datenleitungspaar ausgeben und es somit zu einem Kurzschluß kommen kann. Dabei können die Detektoreinheiten günstiger Weise dezentral direkt dort angeordnet werden, wo die gewünschte Steuerfunktion auszuführen ist. Im geschilderten Fall also direkt am jeweiligen Differenzverstärker.

Gemäß der Erfindung hat der Differenzverstärker eine erste Betriebsart, in der er auf dem Datenleitungspaar befindliche Daten nicht invertiert an das Bitleitungspaar weiterleitet, und eine zweite Betriebsart, in der er die Daten invertiert an das Bitleitungspaar übergibt, wobei die Detektoreinheit bei Auftreten des zweiten Potentialzustandes des Datenleitungspaares die Betriebsart des Differenzverstärkers ändert.

Die Erfindung eignet sich besonders zur Anwendung während eines Testbetriebs des integrierten Speichers. Einund dasselbe auf dem Datenleitungspaar anliegende Datum kann nämlich wahlweise invertiert oder nicht invertiert in die entsprechende Speicherzelle eingeschrieben werden.

Die Erfindung wird im folgenden anhand der Figuren näher erläutert
- Die Figuren 1, 2: zeigen unterschiedliche Ausfuhrungsbeispiele zum besseren Verständnis der Erfindung,
- Figur 3: zeigt eine zugehörige logische Tabellex,
- Figur 4: zeigt eine Ausführungsform der Erfindung.

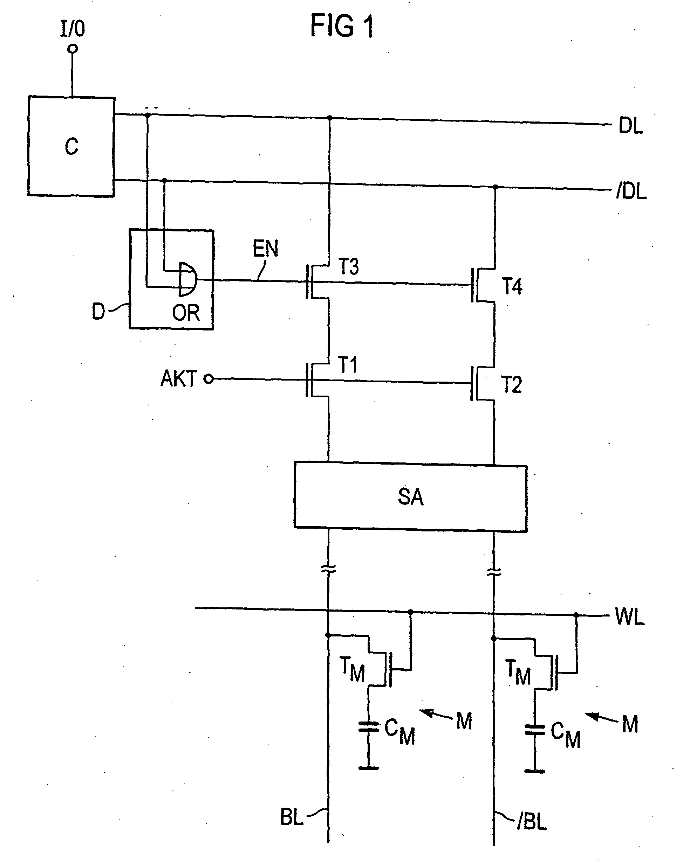

Figur 1 zeigt ein erstes Ausführungsbeispiel eines integrierten Speichers mit einem Datenleitungspaar DL, /DL und einer Steuereinheit C zum Einstellen des Potentials auf den beiden Leitungen des Datenleitungspaares. Weiterhin weist der Speicher in Figur 1 Speicherzellen M auf, die im vorliegenden Fall vom 1-Transistor-DRAM-Speicherzellentyp sind. Die Erfindung ist jedoch auch auf andere Speichertypen anwendbar. Jede der Speicherzellen M weist einen Auswahltransistor TM und einen Speicherkondensator CM auf. Die Gates der Steuertransistoren TM sind mit Wortleitungen WL verbunden, von denen in Figur 1 nur eine dargestellt ist. Der Speicherkondensator CM ist mit seiner einen Elektrode mit Masse und mit seiner anderen Elektrode mit der Source des Auswahltransistors TM verbunden, der ein n-Kanal-Transistor ist. Die Drain des Auswahltransistor TM ist mit einer Bitleitung BL verbunden, die Teil eines Bitleitungspaares BL, /BL ist. Ein Differenzverstärker in Form eines Schreib/Leseverstärkers SA verbindet das Datenleitungspaar mit dem Bitleitungspaar. Der Differenzverstärker SA kann beispielsweise wie im Buch "Semiconductor Memories" von B. Prince (siehe Einleitungsteil dieser Beschreibung) gestaltet sein.

Die Verbindungsleitungen zwischen dem Datenleitungspaar DL, /DL weisen einen ersten Transistor T1 bzw. einen zweiten Transistor T2 auf, deren Gates mit einem Aktivierungssignal AKT verbunden sind. Das Aktivierungssignal AKT dient einer Abkopplung des Datenleitungspaares vom Differenzverstärker SA. Hierauf soll an dieser Stelle aber nicht weiter eingegangen werden. Weiterhin sind zwischen dem Datenleitungspaar und dem Differenzverstärker SA ein dritter Transistor T3 bzw. ein vierter Transistor T4 angeordnet, so daß die erste Leitung DL des Datenleitungspaares über eine Reihenschaltung des dritten Transistors T3 und des ersten Transistors T1 mit einem Anschluß des Differenzverstärkers SA und die zweite Leitung /DL des Datenleitungspaares über eine Reihenschaltung des vierten Transistors T4 und des zweiten Transistors T2 mit einem zweiten Anschluß des Differenzverstärkers verbunden ist.

Der integrierte Speicher aus Figur 1 weist desweiteren eine Detektoreinheit D mit zwei Eingängen auf, die mit je einer der Leitungen des Datenleitungspaares DL, /DL verbunden sind. Die Detektoreinheit D enthält ein ODER-Gatter OR, dessen Eingänge mit den Eingängen der Detektoreinheit D verbunden sind. Ein Ausgang des ODER-Gatters OR ist mit den Gates des dritten T3 und des vierten T4 Transistors verbunden. Am Ausgang des ODER-Gatters OR stellt sich ein Enable-Signal EN ein.

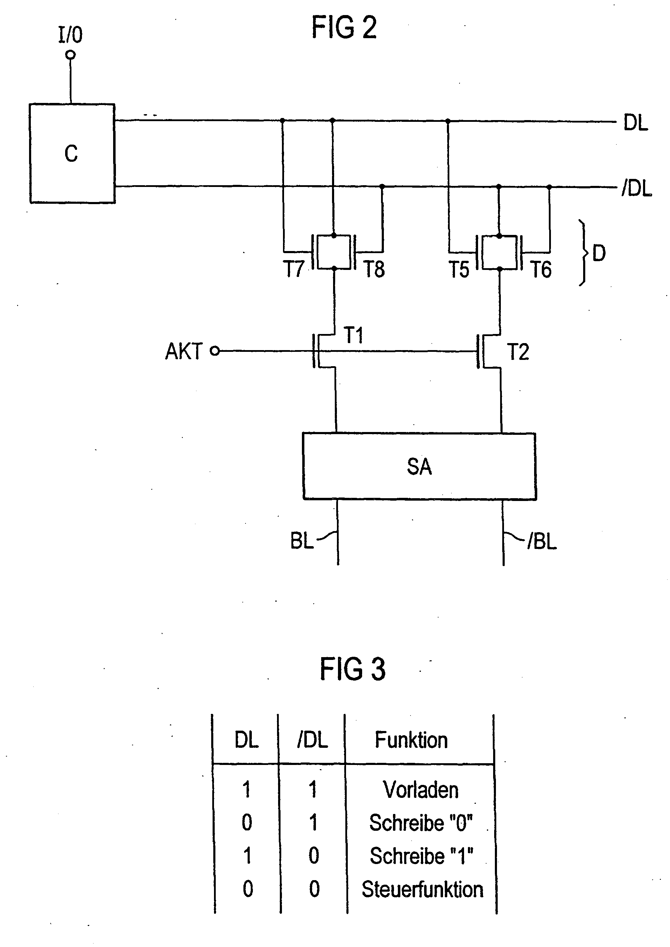

Im folgenden soll anhand Figur 3 die grundsätzliche Funktion sämtlicher hier erläuterter Ausführungsbeispiele erklärt werden. Figur 3 zeigt für verschiedene auszuführende Funktionen die jeweiligen Potentialzustände des Datenleitungspaares DL, /DL. Dabei bezeichnen die Ziffern in Figur 3 logische Zustände, wobei eine "1" einem hohen Pegel (V_{cc}) und eine "0" einem niedrigen Pegel (Masse) entspricht. Figur 3 ist zu entnehmen, daß beim Schreiben einer logischen "0" in eine Speicherzelle M des Speichers die erste Leitung DL des Datenleitungspaares einen niedrigen Pegel aufweist und die zweite Leitung /DL einen hohen Pegel. Beim Schreiben einer logischen "1" verhält es sich genau umgekehrt. Die Potentialzustände des Datenleitungspaares werden dabei von der Steuereinheit C bestimmt. Hierzu ist die Steuereinheit C (siehe Figur 1) mit Anschlüssen I/O verbunden, an die einzuschreibenden Daten angelegt werden können, woraufhin die Steuereinheit die entsprechenden Potentialzustände auf dem Datenleitungspaar erzeugt. Bei einem Lesevorgang lädt die Steuereinheit C beide Leitungen des Datenleitungspaares auf einen hohen Pegel (siehe Figur 3). Dies entspricht einem Vorladen (Precharging) des Datenleitungspaares. Ein anschließend aus einer der Speicherzellen M über das Bitleitungspaar und den Differenzverstärker SA zum Datenleitungspaar übertragenes Datum führt zum Entladen einer der beiden Leitungen des Datenleitungspaares DL, /DL. Die Steuereinheit C erkennt, welche Datenleitung entladen worden ist und schließt daraus, ob es sich um eine gelesene logische "0" oder eine logische "1" handelt. Das auf diese Weise ermittelte Datum gibt die Steuereinheit C an den Anschluß I/O aus.

Gemäß Figur 3 gibt es noch einen weiteren Potentialzustand, der ebenfalls durch die Steuereinheit C eingestellt wird. Bei diesem vierten Potentialzustand weisen die beiden Leitungen des Datenleitungspaares DL, /DL einen niedrigen Pegel auf. Dieser Potentialzustand dient zum Auslösen einer Steuerfunktion durch die Detektoreinheit D. Die hier behandelten Ausführungsbeispiele betreffen unterschiedliche Arten der Auswertung des letztgenannten Potentialzustandes des Datenleitungspaares sowie die daraus resultierende Steuerfunktion.

Betrachten wir nun erneut Figur 1, ist ersichtlich, daß bei Auftreten der in Figur 3 in den ersten drei Zeilen der Tabelle aufgeführten Potentialzustände des Datenleitungspaares am Ausgang der Detektoreinheit D das Enable-Signal EN immer einen hohen Pegel aufweist, so daß der dritte T3 und der vierte T4 Transistor leitend geschaltet sind. Dies hat zur Folge, daß in diesen Fällen der Differenzverstärker SA funktionsfähig ist, sofern das Aktivierungssignal AKT ebenfalls einen hohen Pegel aufweist. Sind in Figur 1 jedoch beide Leitungen des Datenleitungspaares DL, /DL entladen, das heißt sie haben einen niedrigen Pegel (Masse), hat auch das Enable-Signal EN einen niedrigen Pegel und der dritte und der vierte Transistor sind gesperrt. Tritt also in Figur 1 der in Figur 3 in der letzten Zeile der Tabelle angegebene Potentialzustand des Datenleitungspaares auf, wird der Differenzverstärker SA unabhängig vom Zustand des Aktivierungssignals AKT vom Datenleitungspaar abgekoppelt und somit deaktiviert.

Es ist vorteilhaft, die Deaktivierung der Differenzverstärker gesteuert über das ohnehin vorhanden Datenleitungspaar vorzunehmen, anstatt eine separate Enable-Leitung parallel zum Datenleitungspaar zu führen. Durch das Einsparen einer zusätzlichen Steuerleitung ergibt sich ein wesentlicher Flächenvorteil.

Obwohl in Figur 1 das Datenleitungspaar DL, /DL mit nur einem Differenzverstärker SA und einem entsprechenden Bitleitungspaar BL, /BL verbunden ist, sind in der Realität eine Vielzahl von Differenzverstärkern SA und entsprechenden Bitleitungspaaren mit demselben Datenleitungspaar verbunden. Da diese im integrierten Speicher über ein große Fläche verteilt sind, wird jeder der Differenzverstärker SA vorteilhafterweise auf die in Figur 1 gezeigte Art mit dem Datenleitungspaar verbunden und mit einer entsprechenden Detektoreinheit D versehen. Über das Datenleitungspaar sind dann alle Differenzverstärker ohne Notwendigkeit einer zusätzlichen Steuerleitung aktivierbar und deaktivierbar.

Figur 2 zeigt ein zweites Ausführungsbeispiel, das sich von demjenigen in Figur 1 nur auf folgende Weise unterscheidet: Der vierte Transistor T4 wurde durch einen fünften Transistor T5 und einen sechsten Transistor T6 vom n-Kanal-Typ ersetzt, deren Kanalstrecken parallel zueinander geschaltet und zwischen der zweiten Datenleitung /DL und dem zweiten Transistor T2 angeordnet sind. Der dritte Transistor T3 aus Figur 1 wurde durch einen siebten Transistor T7 und einen achten Transistor T8 ersetzt, deren Kanalstrecken ebenfalls parallel zueinander und zwischen der ersten Datenleitung DL und dem ersten Transistor T1 angeordnet sind. Die Gates des siebten Transistors T7 und des fünften Transistors T5 sind mit der ersten Datenleitung DL verbunden. Die Gates des achten Transistors T8 und des sechsten Transistors T6 sind mit der zweiten Datenleitung /DL verbunden.

Die Funktionsweise des Ausführungsbeispiels aus Figur 2 ist die folgende: Bei den in der Tabelle aus Figur 3 in den ersten drei Zeilen eingetragenen Potentialzuständen des Datenleitungspaares ist wenigstens entweder der siebte Transistor T7 oder der achte Transistor T8 leitend. Ebenso ist wenigstens immer der fünfte Transistor T5 oder der sechste Transistor T6 leitend. Der Differenzverstärker ist somit aktiviert, da er Daten von und zu den Datenleitungen übertragen kann (sofern auch der erste T1 und der zweite T2 Transistor leitend geschaltet sind). Weisen dagegen beide Leitungen des Datenleitungspaares DL, /DL einen niedrigen Pegel (Masse) auf, sind alle vier Transistor T5 bis T8 gesperrt und der Differenzverstärker SA ist unabhängig vom Aktivierungssignal AKT vom Datenleitungspaar DL, /DL getrennt und somit deaktiviert. Die durch die vier Transistor T5 bis T8 realisierte Detektoreinheit D bewirkt also ebenso wie diejenige aus Figur 1 eine Deaktivierung des Differenzverstärkers SA, sofern beide Leitungen des Datenleitungspaares niedriges Potential aufweisen.

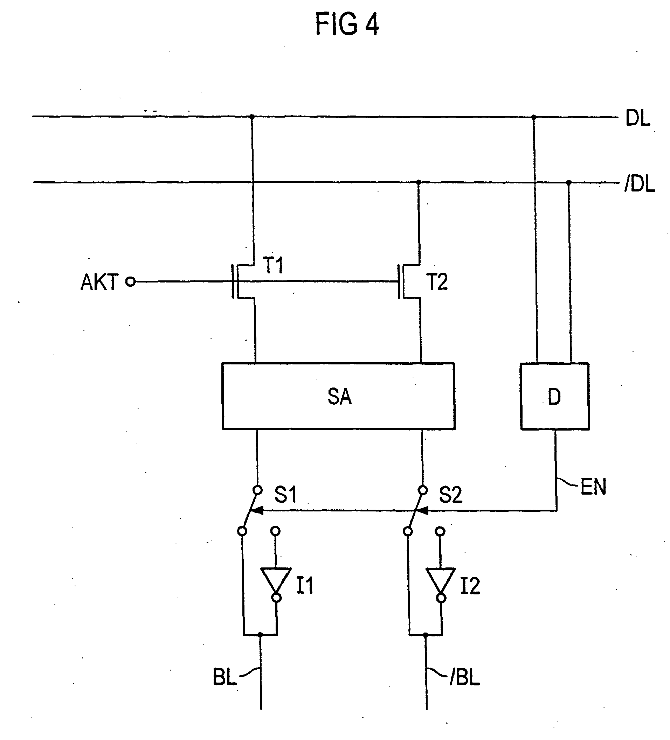

Figur 4 zeigt ein Ausführungsbeispiel der Erfindung, bei dem der Differenzverstärker SA in einer ersten Betriebsart auf dem Datenleitungspaar DL, /DL befindliche Daten nicht invertiert und in einer zweiten Betriebsart invertiert an das Bitleitungspaar BL, /BL weiterleitet. Zu diesem Zweck ist der Differenzverstärker SA über ein erstes Schaltelement S1 in der ersten Betriebsart direkt mit der ersten Bitleitung BL und in der zweiten Betriebsart über einen ersten Inverter I1 mit der ersten Bitleitung BL verbunden. Ebenso ist der Differenzverstärker SA über ein zweites Schaltelement in der ersten Betriebsart direkt mit der zweiten Bitleitung /BL und in der zweiten Betriebsart über einen zweiten Inverter I2 mit der zweiten Bitleitung /BL verbunden. Die Schaltstellung der beiden Schaltelemente S1, S2, die beispielsweise durch Multiplexer realisiert sein können, wird durch das Enable-Signal EN, das die Detektoreinheit D an ihrem Ausgang erzeugt, festgelegt. Die Detektoreinheit D ist so konzipiert, daß sie immer dann, wenn beide Leitungen des Datenleitungspaares DL, /DL einen niedrigen Pegel aufweisen, die Schalterstellung der beiden Schaltelemente S1, S2 verändert und damit einen Wechsel der Betriebsart des Differenzverstärkers auslöst. Die Detektoreinheit D kann zu diesem Zweck beispielsweise ein Wechsel-Flip-Flop enthalten, dessen Ausgang das Enable-Signal EN liefert und dessen Eingang über ein NAND-Gatter mit den beiden Leitungen des Datenleitungspaares DL, /DL verbunden ist. Das NAND-Gatter liefert immer dann an seinem Ausgang einen hohen Pegel, wenn auf beiden Leitungen des Datenleitungspaares niedriges Potential anliegt. Bei jeder positiven Flanke an seinem Eingang wechselt das Wechsel-Flip-Flop den Pegel seines Ausgangssignals, das gleich dem Enable-Signal EN ist.

## Patentansprüche

1. Integrierter Speicher
- mit einem Datenleitungspaar (DL, /DL), das über wenigstens einen Differenzverstärker (SA) mit einem Bitleitungspaar (BL, /BL) verbunden ist,
- bei dem Daten in Form von Differenzsignalen vom Datenleitungspaar über den Differenzverstärker zum Bitleitungspaar und von dort in daran angeschlossene Speicherzellen (M) übertragen werden,
- eine Detektoreinheit (D) vorgesehen ist mit zwei Eingängen, die mit dem Datenleitungspaar verbunden sind,
- eine Steuereinheit (C) vorgesehen ist
-- zum Einstellen von ersten Potentialzuständen auf dem Datenleitungspaar, die den Differenzsignalen von in die Speicherzellen einzuschreibenden Daten entsprechen,
-- und zum Einstellen wenigstens eines zweiten Potentialzustands auf dem Datenleitungspaar, der keinem in die Speicherzellen einzuschreibenden Datum entspricht,
**dadurch gekennzeichnet, dass**
- der Differenzverstärker (SA) in einer ersten Betriebsart auf dem Datenleitungspaar (DL, /DL) befindliche Daten nicht invertiert und in einer zweiten Betriebsart invertiert an das Bitleitungspaar (BL, /BL) weiterleitet,
- wobei die Detektoreinheit bei Auftreten des zweiten Potentialzustands des Datenleitungspaares (DL, /DL) eine bestimmte Steuerfunktion einleitet und die Betriebsart des Differenzverstärkers ändert.

## Claims

1. Integrated memory
- having a data line pair (DL, /DL), which is connected to a bit line pair (BL, /BL) via at least one differential amplifier (SA),
- in which data are transferred in the form of differential signals from the data line pair via the differential amplifier to the bit line pair and from there into memory cells (M) connected thereto,
- a detector unit (D) is provided having two inputs connected to the data line pair,
- control unit (C) is provided
-- for setting first potential states on the data line pair which correspond to the differential signals of data to be written to the memory cells,
-- and for setting at least one second potential state on the data line pair which does not correspond to any datum to be written to the memory cells,
**characterized in that**
- the differential amplifier (SA) forwards data situated on the data line pair (DL, /DL) to the bit line pair (BL, /BL) in a non-inverted manner in a first operating mode and in an inverted manner in a second operating mode,
- the detector unit initiating a specific control function when the second potential state of the data line pair (DL, /DL) occurs and changing the operating mode of the differential amplifier.

## Revendications

1. Mémoire intégrée
- comprenant une paire (DL,/DL) de lignes de données , qui est reliée à une paire (BL,/BL) de lignes de bits par au moins un amplificateur (SA) différentiel,
- dans laquelle des données sous la forme de signaux de différence sont transmis dans la paire de lignes de données à la paire de lignes de bits en passant par l'amplificateur différentiel et de là dans des cellules (M) de mémoire qui y sont raccordées,
- il est prévu une unité (D) de détecteur ayant deux entrées qui sont reliées à la paire de lignes de données,
- il est prévu une unité (C) de commande,
-- pour établir de premiers états de potentiel sur la paire de lignes de données, qui correspondent aux signaux de différence de données à enregistrer dans les cellules de mémoire,
-- et pour établir au moins un deuxième état de potentiel sur la paire de lignes de données, qui correspond au fait qu'il n'y a pas de données à inscrire dans les cellules de mémoire,
**caractérisée en ce que**
- l'amplificateur (SA) différentiel achemine à la paire (BL,/BL) de lignes de bits dans un premier type de fonctionnement des données se trouvant sur la paire (DL,/DL) de lignes de données de façon non inversée et dans un deuxième type de fonctionnement de façon inversée,
- l'unité de détecteur faisant débuter lors de l'apparition du deuxième état de potentiel de la paire (DL,/DL) de lignes de données une fonction de commande déterminée et modifiant le type de fonctionnement de l'amplificateur différentiel.
